# EUROPEAN PATENT SPECIFICATION

(11) **EP 4 220 739 B1**
(45) Date of publication and mention of the grant of the patent: **24.09.2025**
(21) Application number: 23177864.8
(22) Date of filing: 04.10.2021
(51) Int. Cl.: H10F 19/90, H10F 77/20

(54) **PHOTOVOLTAIC CELL AND PHOTOVOLTAIC MODULE**
PHOTOVOLTAIKZELLE UND PHOTOVOLTAIKMODUL
CELLULE PHOTOVOLTAÏQUE ET MODULE PHOTOVOLTAÏQUE

(30) Priority: 27.08.2021 CN 202110998210
(43) Date of publication of application: 02.08.2023
(62) Divisional of application: 21200642.3
(73) Proprietor: Shanghai Jinko Green Energy Enterprise Management Co., Ltd., Shanghai (CN); Zhejiang Jinko Solar Co., Ltd., Haining, Zhejiang 314416 (CN)
(72) Inventor: GUAN, Yingli, HAINING, 314416 (CN); HUANG, Shiliang, HAINING, 314416 (CN); GUO, Zhiqiu, HAINING, 314416 (CN); HAO, Guohui, HAINING, 314416 (CN); CAO, Yuncheng, HAINING, 314416 (CN)
(74) Representative: DREISS Patentanwälte PartG mbB

(56) References cited:
- US-A1- 2014 318 613
- US-A1- 2019 074 391

## Description

### TECHNICAL FIELD

The present disclosure relates to the field of solar energy technologies, and in particular, to a photovoltaic cell and a photovoltaic module.

### BACKGROUND

With the development of technologies, solar devices such as solar modules have become widely applied clean energy supply devices around the world. Generally, a photovoltaic module includes a plurality of photovoltaic cell strings. Each photovoltaic cell string is formed by a plurality of photovoltaic cells connected through a solder strip. A soldering spot is welded to an electrode pad on the photovoltaic cell to play a role of electrical connection. However, the electrode pad on the photovoltaic cell may shield a surface of the photovoltaic cell, thereby affecting light absorption of the photovoltaic cell and then affecting efficiency of the photovoltaic cell.

US 2019/074391A1 discloses a solar cell panel. The solar cell panel includes: a semiconductor substrate, a first conductivity type region and a second conductivity type region formed two sides of the semiconductor substrate respectively, a first electrode electrically connected to the first conductivity type region, and a second electrode electrically connected to the second conductivity type region. The first electrode includes: a plurality of finger lines positioned in a first direction parallel to the long axis and being parallel to each other, and a plurality of bus bars including a plurality of pad portions positioned in a second direction parallel to the short axis. The plurality of pad portions include a first outer pad and a second outer pad located on opposite ends of the plurality of bus bars in the second direction, respectively.

### SUMMARY

The invention is set out in the appended set of claims.

It is to be understood that the general description above and the detailed description in the following are merely illustrative, which shall not be interpreted as limiting the present disclosure.

### BRIEF DESCRIPTION OF DRAWINGS

FIG. 1 is a schematic structural diagram of a photovoltaic cell according to an embodiment of the present disclosure;
FIG. 2 is a partial enlarged view of Position I in FIG. 1;
FIG. 3 is a schematic structural diagram of a first electrode pad according to an embodiment of the present disclosure;
FIG. 4 is a schematic structural diagram of an embodiment of a second electrode pad according to an embodiment of the present disclosure;
FIG. 5 is a schematic structural diagram of another embodiment of the second electrode pad according to an embodiment of the present disclosure;
FIG. 6 is a schematic structural diagram of yet another embodiment of the second electrode pad according to an embodiment of the present disclosure;
FIG. 7 shows a comparison table of embodiments and the related art according to an embodiment of the present disclosure; and
FIG. 8 is a schematic diagram of a relationship between consumption of silver paste and the number of busbars according to an embodiment of the present disclosure.

### Reference signs:

1: busbar;
2: finger;
3: electrode pad;
   31: first electrode pad;
   32: second electrode pad.

The accompanying drawings herein, which are incorporated in and constitute a part of this specification, illustrate embodiments consistent with the present disclosure and, together with the specification, serve to explain principles of the present disclosure.

### DESCRIPTION OF EMBODIMENTS

In order to better understand the technical solutions of the present disclosure, embodiments of the present disclosure are described in detail below with reference to the accompanying drawings.

It should be made clear that the described embodiments are merely some of rather than all of the embodiments of the present disclosure.

The terms used herein in the embodiments of the present disclosure are intended only to describe specific embodiments, and are not intended to limit the present disclosure. As used in the embodiments of the present disclosure and the appended claims, the singular forms of "a/an", "the", and "said" are intended to include plural forms, unless otherwise clearly specified by the context.

It is to be understood that the term "and/or" used herein is merely an association relationship describing associated objects, indicating that three relationships may exist. For example, A and/or B indicates that there are three cases of A alone, A and B together, and B alone. In addition, the character "/" herein generally means that associated objects therebefore and thereafter are in an "or" relationship.

It is to be noted that orientation words such as "up", "down", "left" and "right" described in the embodiments of the present disclosure are described from the angles as shown in the accompanying drawings and should not be understood as limitations to the embodiments of the present disclosure. In addition, in the context, it is to be further understood that, when one element is connected "above" or "below" another element, it can be directly connected "above" or "below" another element, and can be indirectly connected "above" or "below" the another element through an intermediate element.

With the development of technologies, photovoltaic cells have become common solar devices, and the photovoltaic cells may generally be classified into N-type photovoltaic cells and P-type photovoltaic cells. When energy (for example, heat) is added to pure silicon, several electrons may break away from their covalent bonds and leave atoms. Every time an electron leaves, a hole is left. Then, the electrons may wander around lattices, searching for another hole to settle into. The electrons are called free carriers, which can carry currents. When the pure silicon is mixed with phosphorus atoms, only very little energy is required to allow an "extra" electron of the phosphorus atoms (the outermost five electrons) to escape. When the phosphorus atoms are used for doping, the resulting silicon is N-type, and the solar cell is only partially N-type. The other part of silicon is doped with boron which has only three electrons in its outermost electron layer instead of four, resulting in P-type silicon. The P-type silicon has no free electrons. Phosphorus is diffused on a p-type semiconductor material to form a solar cell of a p/n-type structure, i.e., a P-type silicon wafer. Boron is diffused on an N-type semiconductor material to form a solar cell of an n/p-type structure, i.e., an N-type silicon wafer.

An N-type photovoltaic cell includes an N-type silicon wafer, which uses electrons to conduct electricity. A P-type photovoltaic cell includes a P-type silicon wafer, which uses holes to conduct electricity. Generally, silver paste is provided on two sides of the N-type photovoltaic cell. In one possible implementation, the N-type photovoltaic cell may be a Tunnel Oxide Passivated Contact (TOPCon) cell. A substrate of the TOPCon cell is an N-type semiconductor. The substrate has a back side sequentially provided with an ultra-thin tunnel oxide layer, N-type polycrystalline silicon, a backside passivation layer and a metal electrode, and the other side provided with a boron-doped diffusion layer and a metal electrode.

The P-type photovoltaic cell has one side provided with silver paste and the other side provided with aluminum paste and silver paste in combination. In one possible implementation, the P-type photovoltaic cell may be a Passivated Emitter and Rear Contact (PERC) cell. A substrate of the PERC cell is a P-type semiconductor, and the substrate has a front side provided with a passivation layer and a silver electrode and the other side provided with a passivation layer, an aluminum electrode and a silver electrode.

The N-type photovoltaic cell has a longer service life and higher efficiency. The P-type photovoltaic cell is simple in process and low in cost.

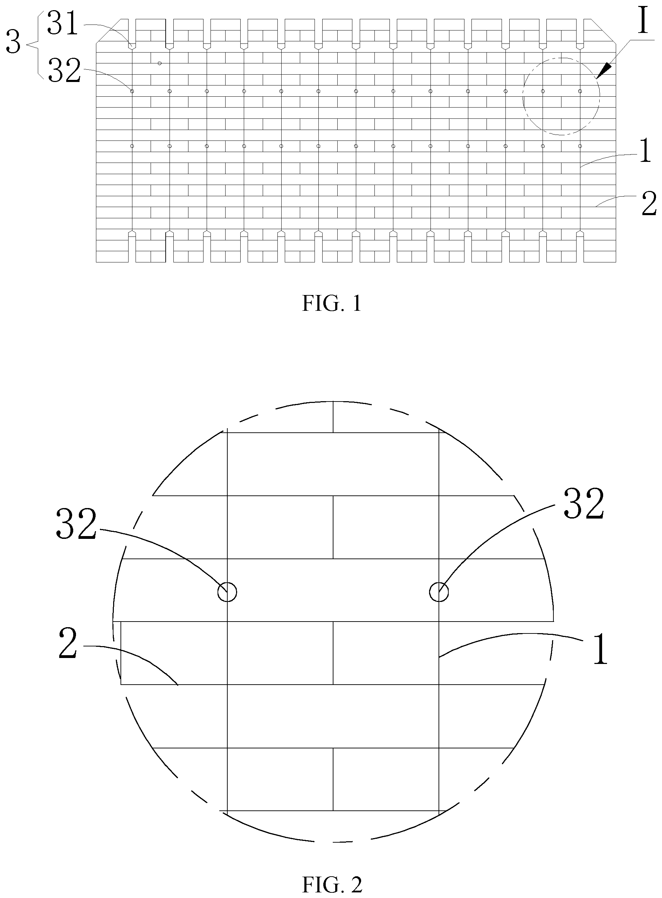

As shown in FIG. 1 and FIG. 2, the present disclosure relates to a photovoltaic cell. The photovoltaic cell includes a substrate and a passivation layer located on a surface of the substrate. The photovoltaic cell converts light energy to electric energy through a PN junction. The PN junction may be manufactured by diffusion to form a diffusion layer. The manufacturing of the passivation layer may increase light conversion efficiency of the photovoltaic cell. The photovoltaic cell further includes a busbar 1 and a finger 2 intersecting with each other on the surface of the substrate. The busbar 1 is electrically connected to the finger 2. The finger 2 is electrically connected to the substrate and configured to collect a current generated by the substrate. The busbar 1 is configured to collect a current from the finger 2. The number of the busbar 1 is 10 to 15, which may be for example 10, 11, 12, 13, 14 or 15. The photovoltaic cell further includes an electrode pad 3 arranged on the surface of the substrate. The number of the electrode pad 3 is 4, 5 or 6. The electrode pad 3 includes first electrode pads 31 and second electrode pads 32. The first electrode pads 31 are located on two ends of the busbar 1. The second electrode pads 32 are located between the first electrode pads 31. The first electrode pad 31 has an area of 0.6 mm² to 1.3 mm², which may be for example 0.6 mm², 0.7 mm², 0.8 mm², 0.9 mm², 1.0 mm², 1.1 mm², 1.2 mm² or 1.3 mm². The second electrode pad 32 has an area of 0.2 mm² to 0.5 mm², which may be for example 0.2 mm², 0.25 mm², 0.3 mm², 0.35 mm², 0.4 mm², 0.45 mm² or 0.5 mm².

The photovoltaic cell according to embodiments of the present disclosure may be applied to solar cells in a size range of 160 mm to 170 mm, which may be applied to, for example, common solar cells with sizes of 161.75 mm, 163.75 mm, 166 mm and the like.

In the existing solution, the number of the busbar 1 is generally 5 to 9. In the present invention, the number of the busbar 1 is set to 10 to 15. An area of a single busbar 1 responsible for current transfer is reduced by increasing the number of the busbar 1 and reducing a spacing between the busbars 1, thereby reducing a current passing through the single busbar 1. Generally, the internal loss of the photovoltaic cell is mainly heat generated during operation. According to a formula Q=I²Rt, where Q is the heat generated during operation, i.e., main internal loss, I is current, R is resistance, and t is operation time. When the current in the circuit decreases, the heat generated is reduced under conditions of constant resistance and fixed operation time, that is, the internal loss is reduced, so as to help improve the overall conversion efficiency of the photovoltaic cell.

Generally, conventional solar cells of a 160+ model are mostly half-cut, provided with seven or more soldering spots. In the present invention, the number of the electrode pad 3 of the half-cut photovoltaic cell is reduced to 4 to 6 compared with the conventional solution in the art. Moreover, the first electrode pad 31 has an area set to 0.6 mm² to 1.3 mm², and the second electrode pad 32 has an area of 0.2 mm² to 0.5 mm². The first electrode pads 31 may be arranged on two opposite sides of the busbar 1. The second electrode pads 32 are located between the first electrode pads 31. Since the first electrode pads 31 are located two opposite ends of the busbar 1, the busbar 1 is generally a straight line. Therefore, when the first electrode pad 31 is successfully welded, positions of the busbar 1 and the solder strip are also relatively fixed.

In an embodiment according to the present disclosure, the number of the busbar 1 is increased, and the current to be collected by a single busbar 1 is reduced. Therefore, a width of each busbar 1 may be reduced, and a diameter of an electrode line may be reduced accordingly. Therefore, the number and the area of the electrode pad 3 required are also relatively reduced while a soldering yield and required soldering pull force are ensured, so as to reduce consumption of the silver paste and help to reduce cost.

In an embodiment of the present disclosure, the shielding of the electrode pad 3 for the substrate can be reduced by adjusting the number and the area of the electrode pad 3, so as to reduce the influence of the electrode pad 3 on light absorption of the substrate and improve operation efficiency of the photovoltaic cell. At the same time, when the area of the electrode pad 3 is reduced, consumed silver paste may also be reduced accordingly, thereby reducing the cost.

The electrode pad 3 is set to a shape of a rectangle, a rhombus, a circle, an ellipse or the like, which can reduce the area of the electrode pad 3 compared with a conventional square structure. This design can reduce the shielding for the substrate, and reduce the consumption of the silver paste and reduce the cost.

The busbar 1 of the photovoltaic cell with an N-type semiconductor substrate has a width of 20 µm to 45 µm, for example, 20 µm, 25 µm, 30 µm, 35 µm, 40 µm, 45 µm or the like.

The number of the busbar 1 of the photovoltaic cell with a P-type semiconductor substrate is 10, 11, 12 or 13. The busbar 1 has a width of 40 µm to 60 µm, for example, 40 µm, 45 µm, 50 µm, 55 µm, 60 µm or the like.

The number of the busbar 1 is increased by adjusting the width of the busbar 1, which can reduce the shielding of the busbar 1 for the substrate, so as to facilitate the substrate absorbing light, thereby improving the operation efficiency of the photovoltaic cell.

Although the decrease in the width of the busbar 1 may lead to an increase in resistance of a single busbar 1, the increased resistance affects the amount of heat generated less than the decrease of the current. Therefore, the overall amount of heat generated of the photovoltaic cell is still reduced compared with the conventional solution.

In one possible implementation, the busbar 1 and/or the finger 2 have/has a dimension less than or equal to 10 µm along a thickness direction of the photovoltaic cell. In the present invention, the first electrode pad 31 and/or the second electrode pad 32 have/has a dimension less than or equal to 8 µm along the thickness direction of the photovoltaic cell.

Compared with a conventional solution, the busbar 1 and/or the finger 2 is reduced in thickness, so that the busbar 1 and/or the finger 2 is reduced in volume; and/or dimensions of the first electrode pad 31 and the second electrode pad 32 along the thickness direction of the photovoltaic cell are reduced, so that the electrode pad 3 is reduced in volume, which may reduce silver paste materials and reduce manufacturing cost.

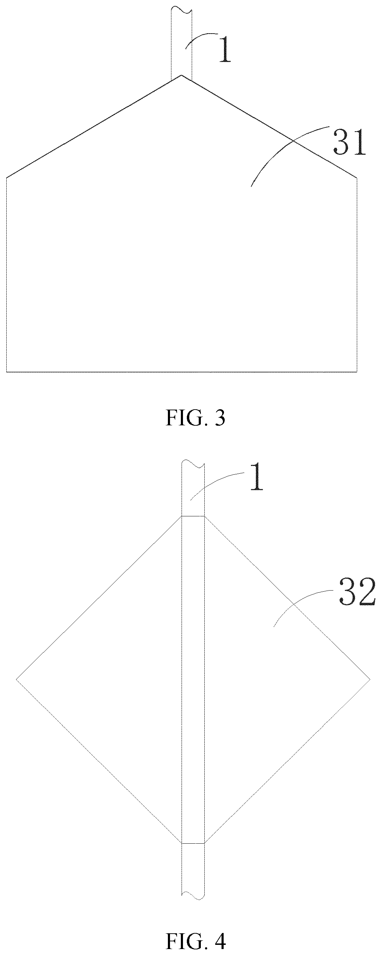

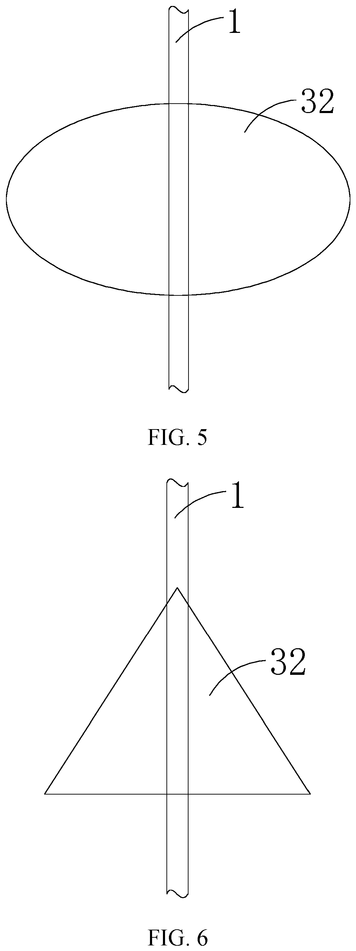

As shown in FIG. 3 to FIG. 6, the first electrode pad 31 and/or the second electrode pad 32 is in a shape of one of a rectangle, a rhombus, a circle and an ellipse or combinations thereof.

The setting of the shape of the first electrode pad 31 and/or the second electrode pad 32, while ensuring connection strength, reduces the area and the shielding area, improves operation efficiency and, at the same time, reduces consumption of silver paste and the manufacturing cost.

In one possible implementation, the first electrode pad 31 has a length and a width respectively between 0.3 mm and 1.1 mm, for example, 0.3 mm, 0.4 mm, 0.5 mm, 0.6 mm, 0.7 mm, 0.8 mm, 0.9 mm, 1.0 mm, 1.1 mm, or the like.

In one possible implementation, the second electrode pad 32 has a length and a width respectively between 0.4 mm and 0.8 mm, for example, 0.4 mm, 0.5 mm, 0.6 mm, 0.7 mm, 0.8 mm, or the like.

When the length and the width correspond to the electrode pad 3 in an elliptical shape, a length range corresponds to a major-axis range of the elliptical shape, and a width range corresponds to a minor-axis range of the elliptical shape.

According to the solution, the lengths and the widths of the first electrode pad 31 and the second electrode pad 32 are reduced, which reduces the area of the electrode pad 3 on the premise of sufficient connection strength, reduces the consumption of the silver paste, lowers the manufacturing cost, and reduces the shielding area of the electrode pad 3, thereby improving the operation efficiency of the photovoltaic cell.

In the present invention, the second electrode pad 32 is in contact with the busbar 1 and is not in contact with the finger 2. That is, the second electrode pad 32 is not arranged at a position where the first electrode pad 31 and the second electrode pad 32 are connected to each other.

This design can reduce the possibility that normal use of the photovoltaic cell is affected by busbar breakage at a position of connection between the busbar 1 and the finger 2 caused by soldering, which is more in line with actual use requirements.

The finger 2 of the photovoltaic cell with the N-type semiconductor substrate has a width of 20 µm to 40 µm. The number of the finger 2 is 80 to 100, for example, 80, 90 or 100. The width of the busbar 1 may be the same as the finger 2.

The finger 2 of the photovoltaic cell with the P-type semiconductor substrate has a width of 20 µm to 45 µm. T number of the finger 2 is 100 to 150, for example, 110, 120, 130, 140, 150 or the like.

In one possible implementation, the P-type photovoltaic cell may have a front surface provided with 109 to 123 fingers 2 and a back surface provided with 123 to 139 fingers 2. Silver, which is expensive, is used on the front surface of the P-type photovoltaic cell to conduct electricity. Therefore, the number of the finger 2 may be reduced appropriately, and aluminum, which is less expensive, and a small amount of silver are used on the back surface to conduct electricity. Therefore, the number of the finger 2 may be appropriately increased on the back surface to improve the operation efficiency of the photovoltaic cell.

In the solution according to an embodiment of the present disclosure, the shielding of the finger 2 for the substrate can be reduced by reducing the number of the finger 2, so as to facilitate the substrate absorbing light and improve the operation efficiency of the photovoltaic cell.

Compared with the conventional solution, according to the present disclosure, the busbar 1 has a narrower width and a larger quantity, the electrode pad 3 has a smaller quantity (a smaller number of soldering pads), and the electrode pad 3 has a smaller area, which can reduce the consumption of the silver paste and help reduce the cost.

The present disclosure relates to a photovoltaic module. The photovoltaic module includes glass, a first film material, a photovoltaic cell string, a second film material, and a back sheet sequentially from front to back, wherein the photovoltaic cell string includes a plurality of photovoltaic cells, and the photovoltaic cell is the photovoltaic cell described in any item above.

The glass on the front surface of the photovoltaic cell protects and transmits light. The first film material and the second film material are configured to bond and fix the glass and the photovoltaic cell string. The photovoltaic cell string is configured to convert light energy into electric energy. The back sheet has functions of sealing, insulation and water resistance.

In one possible implementation, the photovoltaic cells are connected through an electrode line. The electrode line has a diameter of 0.25 mm to 0.32 mm, for example, 0.25 mm, 0.26 mm, 0.27 mm, 0.28 mm, 0.29 mm, 0.30 mm, 0.31 mm, 0.32 mm or the like.

Compared with the existing solution, a thinner electrode line is used, and an area of shielding of the solder strip for the cell is reduced, which improves the operation efficiency of the cell.

In one possible implementation, the electrode line may be partially flattened to form a flat structure at a position where the electrode line corresponds to the electrode pad 3. This design can increase a contact area between the electrode line and electrode pad 3 when the electrode line is in contact with the electrode pad 3. In another possible implementation, the flat structure is formed at a position where the electrode line corresponds to the first electrode pad 31, because the first electrode pad serves as a main electrode pad.

In one possible implementation, the first film material and/or the second film material have/has a weight of 300 g/m² to 500 g/m².

Compared with the existing solution, in an embodiment according to the present disclosure, less silver paste is consumed, the electrode line is thinner, the electrode line is less reduced, the electrode line is less likely to puncture the film material, and thus the first film material and/or the second film material with less grammage, for example, ethylene vinyl acetate (EVA) or polyolefin elastomer (POE), may be selected, so as to reduce the manufacturing cost.

It is to be noted herein that the data exemplified in the present disclosure are only preferred and common data within the data range according to an embodiment of the present disclosure, and the rest is not listed. However, data within the data range according to the present disclosure can achieve the corresponding technical effect.

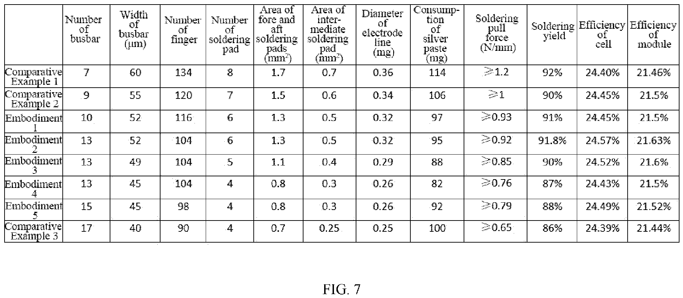

As shown in FIG. 7, the following table is obtained upon test. The embodiments are solutions according to the present disclosure, which are specifically technical effects achieved by a 163 cell, and the comparative examples are existing conventional solutions. It may be obtained from Comparative Example 1, Comparative Example 2 and Embodiment 1 to Embodiment 5 that, the number of the finger 2 may be reduced when the number of the busbar 1 is increased, and the current to be collected by a single busbar 1 is reduced when the number of the busbar 1 is increased. Therefore, a width of each busbar 1 may be reduced, and the diameter of the electrode line may be reduced at the same time. Therefore, the number and the area of the electrode pad 3 required are also relatively reduced while a soldering yield and required soldering pull force are ensured, so as to effectively reduce cost. Generally, processing requirements may be met when a minimum value of the soldering pull force is greater than 0.75 N. It may be known from the table that compared with Comparative Examples 1 and 2, Embodiments 1 to 5 can still meet the requirements of the soldering pull force while reducing the consumption of the silver paste and reducing the cost, which has a soldering yield fluctuating slightly, so as to meet actual use requirements. At the same time, it may be obtained from the data in the table that, compared with the comparative examples, the embodiments further improve the efficiency of the cell and the efficiency of the module while reducing the cost, which is more in line with the actual use requirements.

It may be obtained from Embodiments 2 to 4 that, when the number of the busbar 1 and the number of the finger 2 are fixed, if the width of the busbar 1 is smaller, the number of the soldering spot is smaller, the area is smaller, and less silver paste is consumed. At the same time, the width of the busbar 1 is reduced, and the diameter of the electrode line may also be relatively reduced. Therefore, less silver paste is consumed.

It may be obtained from Embodiments 4 and 5 that, when the area of the electrode pad 3 is fixed, even if the number of the finger 2 is reduced, the consumption of the silver paste may also be increased due to the increase in the number of the busbar 1. Therefore, the number of the busbar 1 has greater influence on the consumption of the silver paste than the number of the finger 2.

In the solution according to the present disclosure, the number of the busbar 1 ranges from 10 to 15. When the number of the busbar 1 exceeds 15, it may be obtained from Embodiments 1 to 5 and Comparative Example 3 that, in Comparative Example 3, the number of the busbar 1 is increased, the width is reduced, and the area of the soldering spot is reduced. In this case, although the number of the finger 2 is reduced, the consumption of the silver paste is increased due to an excessive number of the busbar 1. Moreover, the soldering pull force cannot meet the processing requirements, and the efficiency of the cell and the efficiency of the module are evidently reduced compared with each embodiment, so the cost performance is low in actual use, which does not meet actual manufacturing and use requirements.

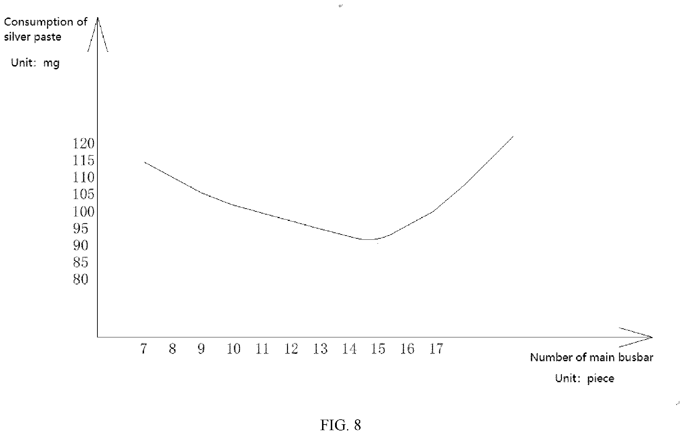

As shown in FIG. 8, with an increase in the number of the busbar 1 and a decrease in the number of the finger 2, a curve of the consumption of the silver paste is an inverse parabola. When the number of the busbar 1 exceeds 15, a reduction in the silver paste caused by the decrease in the number of the finger 2 is less than an increase in the silver paste caused by the increase in the number of the busbar 1. Overall, the consumption of the silver paste increases significantly, which increases the cost, and reduces the soldering yield, and the efficiency of the cell and the efficiency of the module to some extent.

The above are only preferred embodiments of the present disclosure and are not intended to limit the present disclosure. For those skilled in the art, the present disclosure may have various modifications and variations.

## Claims

1. A photovoltaic cell, comprising:
a substrate;
a passivation layer located on at least one surface of the substrate;
a plurality of busbars (1) and a plurality of fingers (2) that are intersect with each other on a front surface of the substrate, wherein the plurality of busbar (1) is electrically connected to the plurality of fingers (2); and
a plurality of electrode pads (3) arranged on the front surface of the substrate, wherein each of the plurality of busbars (1) is connected to 4 to 6 electrode pads (3) of the plurality of electrode pads (3), the 4 to 6 electrode pads (3) include first electrode pads (31) and second electrode pads (32), the first electrode pads are located on two ends of each of the plurality of busbars (1), and the second electrode pads (32) are located between the first electrode pads (31),
wherein the first electrode pads (31) each have an area of 0.6 mm² to 1.3 mm², and the second electrode pads (32) each have an area of 0.2 mm² to 0.5 mm²,
wherein the first electrode pads (31) and/or the second electrode pads (32) each have a shape of any one of a rectangle, a rhombus, a circle, an ellipse or combinations thereof, and
wherein the substrate is an N-type semiconductor, a quantity of the plurality of busbars (1) is 10 to 15, each busbar (1) has a width of 20 µm to 45 µm, a quantity of the plurality of fingers (2) is 80 to 100, and each of the plurality of fingers (2) has a width of 20 µm to 40 µm, or wherein the substrate is a P-type semiconductor, a quantity of the plurality of busbars (1) is 10 to 13, each busbar (1) has a width of 40 µm to 60 µm, the quantity of the plurality of fingers (2) is 100 to 150, and each of the plurality of fingers (2) has a width of 20 to 45 µm,
wherein the first electrode pads (31) and/or the second electrode pads (32) each have a dimension less than or equal to 8 µm along the thickness direction of the photovoltaic cell, and
wherein the second electrode pads (32) are not in contact with the fingers (2).

2. The photovoltaic cell according to claim 1, wherein at least one busbar (1) of the plurality of busbars (1) and/or at least one finger (2) of the plurality of fingers (2) has a dimension less than or equal to 10 µm along a thickness direction of the photovoltaic cell.

3. The photovoltaic cell according to claim 1, wherein the first electrode pads (31) each have a length and a width respectively between 0.3 mm and 1.1 mm.

4. The photovoltaic cell according to claim 1, wherein the second electrode pads (32) each have a length and a width respectively between 0.4 mm and 0.8 mm.

5. The photovoltaic cell according to any one of claims 1 to 4, wherein each of the second electrode pads (32) is in contact with one busbar (1) of the plurality of busbars (1) and is not in contact with the plurality of fingers (2).

6. The photovoltaic cell according to any one of claims 1 to 4, wherein when the substrate is the P-type semiconductor, the quantity of the plurality of fingers (2) on the front surface of the substrate is 109 or 123, and the photovoltaic cell further comprises 123 to 139 fingers on a back surface of the substrate,
wherein the plurality of fingers (2) on the front surface of the substrate are made of silver, and the fingers on the back surface of the substrate are made of silver and aluminum.

7. The photovoltaic cell according to claim 1, wherein when the substrate is the N-type semiconductor, each busbar (1) has a width of 20 µm to 30 µm.

8. A photovoltaic module, comprising glass, a first film material, a photovoltaic cell string, a second film material, and a back sheet sequentially from a front side to a back side, wherein the photovoltaic cell string comprises a plurality of photovoltaic cells, and each of the plurality of photovoltaic cells is the photovoltaic cell according to any one of claims 1 to 7.

9. The photovoltaic module according to claim 8, wherein the plurality of photovoltaic cells are connected through an electrode line, and the electrode line has a diameter of 0.25 mm to 0.32 mm.

10. The photovoltaic module according to claim 8, wherein the first film material and/or the second film material has a weight of 300 g/m² to 500 g/m².

11. The photovoltaic module according to claim 9, wherein the electrode line is partially flattened to form a flat structure at a position where the electrode line corresponds to the electrode pad (3).

12. The photovoltaic module according to claim 11, wherein the flat structure is formed at the position where the electrode line corresponds to the first electrode pad (31).

## Patentansprüche

1. Photovoltaikzelle, umfassend:
ein Substrat;
eine Passivierungsschicht, die sich auf mindestens einer Oberfläche des Substrats befindet;
eine Vielzahl von Sammelschienen (1) und eine Vielzahl von Fingern (2), die sich auf einer Vorderseite des Substrats kreuzen, wobei die Vielzahl von Sammelschienen (1) elektrisch mit der Vielzahl von Fingern (2) verbunden ist; und
eine Vielzahl von Elektrodenpads (3), die auf der Vorderseite des Substrats angeordnet sind, wobei jede der Vielzahl von Sammelschienen (1) mit 4 bis 6 Elektrodenpads (3) der Vielzahl von Elektrodenpads (3) verbunden ist, die 4 bis 6 Elektrodenpads (3) erste Elektrodenpads (31) und zweite Elektrodenpads (32) einschließen, die ersten Elektrodenpads sich an zwei Enden jeder der Vielzahl von Sammelschienen (1) befinden und die zweiten Elektrodenpads (32) sich zwischen den ersten Elektrodenpads (31) befinden, wobei die ersten Elektrodenpads (31) jeweils eine Fläche von 0,6 mm² bis 1,3 mm² aufweisen und die zweiten Elektrodenpads (32) jeweils eine Fläche von 0,2 mm² bis 0,5 mm² aufweisen,
wobei die ersten Elektrodenpads (31) und/oder die zweiten Elektrodenpads (32) jeweils die Form eines Rechtecks, einer Raute, eines Kreises, einer Ellipse oder Kombinationen davon aufweisen, und
wobei das Substrat ein N-Typ-Halbleiter ist, die Anzahl der Sammelschienen (1) 10 bis 15 beträgt, jede Sammelschiene (1) eine Breite von 20 µm bis 45 µm aufweist, die Anzahl der Finger (2) 80 bis 100 beträgt und jeder der Vielzahl von Fingern (2) eine Breite von 20 µm bis 40 µm aufweist, oder wobei das Substrat ein P-Typ-Halbleiter ist, die Anzahl der Vielzahl von Sammelschienen (1) 10 bis 13 beträgt, jede Sammelschiene (1) eine Breite von 40 µm bis 60 µm aufweist, die Anzahl der Vielzahl von Fingern (2) 100 bis 150 beträgt und jeder der Vielzahl von Fingern (2) eine Breite von 20 bis 45 µm aufweist,
wobei die ersten Elektrodenpads (31) und/oder die zweiten Elektrodenpads (32) jeweils eine Abmessung kleiner oder gleich 8 µm entlang der Dickenrichtung der Photovoltaikzelle aufweisen, und
wobei die zweiten Elektrodenpads (32) nicht mit den Fingern (2) in Kontakt sind.

2. Photovoltaikzelle nach Anspruch 1, wobei mindestens eine Sammelschiene (1) der Vielzahl von Sammelschienen (1) und/oder mindestens ein Finger (2) der Vielzahl von Fingern (2) eine Abmessung kleiner oder gleich 10 µm entlang einer Dickenrichtung der Photovoltaikzelle aufweist.

3. Photovoltaikzelle nach Anspruch 1, wobei die ersten Elektrodenpads (31) jeweils eine Länge und eine Breite zwischen 0,3 mm und 1,1 mm aufweisen.

4. Photovoltaikzelle nach Anspruch 1, wobei die zweiten Elektrodenpads (32) jeweils eine Länge und eine Breite zwischen 0,4 mm und 0,8 mm aufweisen.

5. Photovoltaikzelle nach einem der Ansprüche 1 bis 4, wobei jedes der zweiten Elektrodenpads (32) mit einer Sammelschiene (1) der Vielzahl von Sammelschienen (1) in Kontakt steht und nicht mit der Vielzahl von Fingern (2) in Kontakt steht.

6. Photovoltaikzelle nach einem der Ansprüche 1 bis 4, wobei, wenn das Substrat ein P-Typ-Halbleiter ist, die Anzahl der Finger (2) auf der Vorderseite des Substrats 109 oder 123 beträgt und die Photovoltaikzelle ferner 123 bis 139 Finger auf einer Rückseite des Substrats umfasst,
wobei die Vielzahl von Fingern (2) auf der Vorderseite des Substrats aus Silber hergestellt sind und die Finger auf der Rückseite des Substrats aus Silber und Aluminium hergestellt sind.

7. Photovoltaikzelle nach Anspruch 1, wobei, wenn das Substrat ein N-Typ-Halbleiter ist, jede Sammelschiene (1) eine Breite von 20 µm bis 30 µm aufweist.

8. Photovoltaikmodul, umfassend, nacheinander von einer vorderen Seite zu einer hinteren Seite, ein Glas, ein erstes Folienmaterial, einen Photovoltaikzellenstrang, ein zweites Folienmaterial und eine hintere Bahn, wobei der Photovoltaikzellenstrang eine Vielzahl von Photovoltaikzellen umfasst und jede der Vielzahl von Photovoltaikzellen die Photovoltaikzelle nach einem der Ansprüche 1 bis 7 ist.

9. Photovoltaikmodul nach Anspruch 8, wobei die Vielzahl von Photovoltaikzellen über eine Elektrodenleitung verbunden sind und die Elektrodenleitung einen Durchmesser von 0,25 mm bis 0,32 mm aufweist.

10. Photovoltaikmodul nach Anspruch 8, wobei das erste Folienmaterial und/oder das zweite Folienmaterial ein Gewicht von 300 g/m² bis 500 g/m² aufweist.

11. Photovoltaikmodul nach Anspruch 9, wobei die Elektrodenleitung teilweise abgeflacht ist, um an einer Position, an der die Elektrodenleitung dem Elektrodenpad (3) entspricht, eine flache Struktur zu bilden.

12. Photovoltaikmodul nach Anspruch 11, wobei die flache Struktur an der Position gebildet ist, an der die Elektrodenleitung dem ersten Elektrodenpad (31) entspricht.

## Revendications

1. Cellule photovoltaïque, comprenant :
un substrat ;
une couche de passivation située sur au moins une surface du substrat ;
une pluralité de barres omnibus (1) et une pluralité de doigts (2) qui se croisent les uns les autres sur une surface avant du substrat, dans laquelle la pluralité de barres omnibus (1) est connectée électriquement à la pluralité de doigts (2) ; et
une pluralité de plots d'électrodes (3) disposés sur la surface avant du substrat, dans laquelle chacune de la pluralité de barres omnibus (1) est connectée à 4 à 6 plots d'électrodes (3) de la pluralité de plots d'électrodes (3), les 4 à 6 plots d'électrodes (3) comportent des premiers plots d'électrodes (31) et des seconds plots d'électrodes (32), les premiers plots d'électrodes sont situés sur deux extrémités de chacune de la pluralité de barres omnibus (1), et les seconds plots d'électrodes (32) sont situés entre les premiers plots d'électrodes (31), dans laquelle les premiers plots d'électrodes (31) ont chacun une surface de 0,6 mm² à 1,3 mm², et les seconds plots d'électrodes (32) ont chacun une surface de 0,2 mm² à 0,5 mm²,
dans laquelle les premiers plots d'électrodes (31) et/ou les seconds plots d'électrodes (32) ont chacun une forme de l'un quelconque parmi un rectangle, un losange, un cercle, une ellipse ou une combinaison de ceux-ci, et
dans laquelle le substrat est un semi-conducteur de type N, une quantité de la pluralité de barres omnibus (1) est de 10 à 15, chaque barre omnibus (1) a une largeur de 20 µm à 45 µm, une quantité de la pluralité de doigts (2) est de 80 à 100, et chacun de la pluralité de doigts (2) a une largeur de 20 µm à 40 µm, ou dans laquelle le substrat est un semi-conducteur de type P, une quantité de la pluralité de barres omnibus (1) est de 10 à 13, chaque barre omnibus (1) a une largeur de 40 µm à 60 µm, la quantité de la pluralité de doigts (2) est de 100 à 150, et chacun de la pluralité de doigts (2) a une largeur de 20 à 45 µm,
dans laquelle les premiers plots d'électrodes (31) et/ou les seconds plots d'électrodes (32) ont chacun une dimension inférieure ou égale à 8 µm le long de la direction de l'épaisseur de la cellule photovoltaïque, et
dans laquelle les seconds plots d'électrodes (32) ne sont pas en contact avec les doigts (2).

2. Cellule photovoltaïque selon la revendication 1, dans laquelle au moins une barre omnibus (1) de la pluralité de barres omnibus (1) et/ou au moins un doigt (2) de la pluralité de doigts (2) a une dimension inférieure ou égale à 10 µm le long d'une direction de l'épaisseur de la cellule photovoltaïque.

3. Cellule photovoltaïque selon la revendication 1, dans laquelle les premiers plots d'électrodes (31) ont chacun une longueur et une largeur respectivement comprises entre 0,3 mm et 1,1 mm.

4. Cellule photovoltaïque selon la revendication 1, dans laquelle les seconds plots d'électrodes (32) ont chacun une longueur et une largeur respectivement comprises entre 0,4 mm et 0,8 mm.

5. Cellule photovoltaïque selon l'une quelconque des revendications 1 à 4, dans laquelle chacun des seconds plots d'électrodes (32) est en contact avec une barre omnibus (1) de la pluralité de barres omnibus (1) et n'est pas en contact avec la pluralité de doigts (2).

6. Cellule photovoltaïque selon l'une quelconque des revendications 1 à 4, dans laquelle, lorsque le substrat est le semi-conducteur de type P, la quantité de la pluralité de doigts (2) sur la surface avant du substrat est de 109 ou 123, et la cellule photovoltaïque comprend en outre 123 à 139 doigts sur une surface arrière du substrat,
dans laquelle la pluralité de doigts (2) sur la surface avant du substrat sont en argent, et les doigts sur la surface arrière du substrat sont en argent et en aluminium.

7. Cellule photovoltaïque selon la revendication 1, dans laquelle, lorsque le substrat est le semi-conducteur de type N, chaque barre omnibus (1) a une largeur de 20 µm à 30 µm.

8. Module photovoltaïque, comprenant du verre, un premier matériau de film, une chaîne de cellules photovoltaïques, un second matériau de film, et une feuille arrière séquentiellement d'un côté avant vers un côté arrière, dans lequel la chaîne de cellules photovoltaïques comprend une pluralité de cellules photovoltaïques, et chacune de la pluralité de cellules photovoltaïques est la cellule photovoltaïque selon l'une quelconque des revendications 1 à 7.

9. Module photovoltaïque selon la revendication 8, dans lequel la pluralité de cellules photovoltaïques sont connectées par l'intermédiaire d'une ligne d'électrode, et la ligne d'électrode a un diamètre de 0,25 mm à 0,32 mm.

10. Module photovoltaïque selon la revendication 8, dans lequel le premier matériau de film et/ou le second matériau de film a un poids de 300 g/m² à 500 g/m².

11. Module photovoltaïque selon la revendication 9, dans lequel la ligne d'électrode est partiellement aplatie afin de former une structure plate à une position où la ligne d'électrode correspond au plot d'électrode (3).

12. Module photovoltaïque selon la revendication 11, dans lequel la structure plate est formée à la position où la ligne d'électrode correspond au premier plot d'électrode (31).
